# FASCICULE DE BREVET EUROPEEN

(11) **EP 2 893 640 B1**
(45) Date de publication et mention de la délivrance du brevet: **27.06.2018**
(21) Numéro de dépôt: 13756415.9
(22) Date de dépôt: 27.08.2013
(51) Int. Cl.: H03K 17/969, B60K 37/06, G01D 5/347

(54) **DISPOSITIF A ORGANE DE COMMANDE MOBILE**
VORRICHTUNG MIT EINER BEWEGLICHEN STEUEREINHEIT
DEVICE HAVING A MOVABLE CONTROL UNIT

(30) Priorité: 05.09.2012 FR 1258279
(43) Date de publication de la demande: 15.07.2015
(73) Titulaire: Delphi Technologies, Inc., Troy, MI 48007 (US)
(72) Inventeur: HOLL, Jean-Sébastien, F-67730 Chatenois (FR); LA PAGLIA, Anthony, F-67400 Illkirch (FR); RASSENT, Maxime, F-67100 Strasbourg (FR)
(74) Mandataire: Robert, Vincent
(86) Numéro de dépôt international: PCT/EP2013/067720
(87) Numéro de publication internationale: WO 2014/037248

(56) Documents cités:
- FR-A1- 2 590 100
- US-A1- 2006 227 454

## Description

### DOMAINE TECHNIQUE

La présente invention est relative à un dispositif de commande pourvu d'un organe mobile dont les déplacements sont identifiés par un détecteur à capteurs binaires.

### ARRIERE-PLAN TECHNOLOGIQUE DE L'INVENTION

On connaît des dispositifs à organe de commande orientable installés dans les véhicules et manipulables par le conducteur qui doit cependant rester concentré sur sa conduite. Ces dispositifs sont généralement reliés à un afficheur et l'utilisateur doit déplacer l'organe de commande dans le but de déplacer un curseur dans un menu ou pour faire défiler des commandes. A partir d'une position neutre stable, l'organe de commande est déplaçable vers l'avant, l'arrière, vers la droite ou vers la gauche. Les organes de commande peuvent de plus être tournés autour d'un axe normal. Il arrive qu'ils soient également déplaçable en biais, entre les positions avant, droite, arrière et gauche. Une fois la commande désirée atteinte, elle peut être validée par un simple appui sur l'organe de commande qui se déplace à l'instar d'une touche de clavier d'ordinateur.

L'utilisateur ne regardant pas l'organe de commande, il est primordial qu'en dehors de toute manipulation l'organe de commande soit maintenu dans la position neutre de manière stable. Il est également important que les déplacements demandent de légers efforts. Les rotations sont quant à elles généralement accompagnées d'une petite force cyclique. À ces efforts créés dans le seul but d'apporter confort et précision sont ajoutés les efforts nécessaires pour commuter des capteurs ou des micro-interrupteurs. L'addition des efforts volontaires et des efforts nécessaires n'est pas exempte de variations indésirables.

De plus, les déplacements vers l'avant, l'arrière, la droite ou la gauche sont généralement le résultat de petites rotations, voir par exemple US 2006/227454 A1. Il apparait que de vraies translations sont mieux perçues par l'utilisateur.

### RESUME DE L'INVENTION

La présente invention vise à remédier aux inconvénients mentionnés précédemment en proposant une solution simple et économique. Dans ce but, l'invention propose un dispositif de commande destiné au choix et à la sélection de fonctions dans un véhicule selon la revendication indépendante 1. Le dispositif comprend trois capteurs actifs binaires, agencés sur une carte électronique fixée dans un boitier, les capteurs commutant au passage de marqueurs passifs agencés sur un support qui peut être déplacé au moyen d'un organe de commande manipulable. Le support est déplaçable en translation selon un premier axe principal longitudinal vers une position avant et une position arrière et perpendiculairement selon un second axe principal transversal vers une position droite et une position gauche. Le support est également déplaçable en rotation autour d'un axe normal perpendiculaire aux axes principaux dans le sens horaire et dans le sens anti-horaire.

Le support de marqueurs et l'organe de commande sont de plus en liaison avec un moyen d'indexation et de rappel qui les sollicite en permanence vers une position neutre.

Les capteurs et les marqueurs étant agencés relativement les uns aux autres de sorte que chacune des cinq positions, neutre, avant, arrière, droite, gauche ainsi que chacune des deux rotations horaire et anti-horaire est individuellement identifiée par une signature binaire à trois chiffres émise par les capteurs.

Cet arrangement autorise les vraies translations de l'organe de commande mais il peut cependant être adapté aux dispositifs dont l'organe de commande se déplace selon de petites rotations.

L'organe de commande et le support de marqueurs sont de plus mobiles en translation dans quatre directions coplanaires et intermédiaires des axes principaux depuis la position neutre vers une position avant-droite et vers une position arrière-gauche et vers une position avant-gauche et une position arrière-droite, le dispositif étant pourvu d'un quatrième capteur actif binaire. Les quatre capteurs et les marqueurs sont agencés relativement les uns aux autres de sorte que chacune des neuf positions, neutre, avant, arrière, droite, gauche et intermédiaires ainsi que chacune des deux rotations horaire et anti-horaire est individuellement identifiée par une signature binaire à quatre chiffres émise par les capteurs.

Plus précisément, le support de marqueurs comprend une surface de révolution d'axe normal, à la périphérie de laquelle les marqueurs sont agencés avec régularité selon un espacement angulaire constant. La signature neutre de la position neutre est émise chaque fois que le support de marqueurs tourne, dudit angle d'espacement angulaire et donc, la signature neutre de la position neutre est émise plusieurs fois par révolution du support de marqueurs.

A la suite d'une rotation, le moyen d'indexation et de rappel immobilise le support de marqueurs en une position angulaire stable identifiée par la signature neutre. Le moyen d'indexation et de rappel comprend une couronne dentée solidaire du support de marqueurs et un indexeur pressé contre la couronne par un moyen élastique, l'indexeur et le moyen élastique étant maintenus solidaire du boitier. La couronne a autant de dents que le support de marqueurs a de position angulaire identifiée par la signature neutre. La couronne est agencée sur le support de sorte qu'à l'arrêt, l'indexeur se trouve pressé entre deux dents de la couronne stabilisant le support en une des positions angulaires stables identifiées par la signature neutre.

Trois capteurs peuvent émettre un total de huit signatures binaires différentes et quatre capteurs peuvent émettre seize signatures binaires différentes. Les signatures binaires encore disponibles peuvent avantageusement être utilisées pour identifier des fonctions supplémentaires actionnées par l'intermédiaire de nouveaux déplacements de l'organe de commande ou d'actionneurs supplémentaires dédiés.

Notamment, le dispositif peut être pourvu d'un moyen annexe de commande activé par un appui selon l'axe normal sur l'organe de commande. Cette action peut notamment être utilisée pour valider une fonction. L'organe de commande translate alors de la position neutre vers une position appuyée et actionne le moyen annexe de commande qui fait commuter les capteurs. Les capteurs émettent alors une signature binaire identifiant la position appuyée, le moyen d'indexation et de rappel sollicitant l'organe de commande vers un retour à la position neutre.

Dans un mode de réalisation préféré, les capteurs sont des capteurs optiques émetteur et récepteur d'un rayon lumineux. La partie du support de marqueurs agencée en regard des capteurs est une surface réfléchissante du rayon lumineux et, les marqueurs sont des zones non réfléchissantes par exemple des ouvertures au travers desquelles passe le rayon lumineux. Un capteur émettant un rayon lumineux incident commute lorsqu'au passage d'un marqueur le rayon lumineux ne lui est plus réfléchit. Cet agencement de capteurs optique présente l'avantage de ne pas générer de frottements parasites.

Enfin, le dispositif est pourvu de moyens de guidage guidant les déplacements de l'organe de commande en translation et en rotation.

### BREVE DESCRIPTION DES DESSINS

D'autres caractéristiques buts et avantages de l'invention apparaîtront à la lecture de la description détaillée qui suit, et en regard des dessins annexés, donnés à titre d'exemple non limitatif et sur lesquels:
- la Figure 1 est un schéma de liaison fonctionnelle entre le dispositif et son environnement.
- la Figure 2 est une vue isométrique d'un dispositif de commandes réalisé selon l'invention.
- La Figure 3 est une coupe transversale d'un détecteur de positions et de déplacements utilisé dans le dispositif des Figures 1 et 2.
- La Figure 4 est un schéma illustrant les déplacements d'un marqueur faisant commuter un capteur utilisé dans le détecteur de la Figure 3.
- La séquence des Figures 5 à 15 représente la configuration du détecteur de la Figure 3 selon les positions et déplacements réalisés.
- La Figure 16 est une alternative à la construction de la Figure 5.
- La Figure 17 est un schéma de réalisation d'un moyen annexe de validation du dispositif de la Figure 1.
- La Figure 18 est une vue de dessus du détecteur de la Figure 5 équipé du moyen de validation non activé de la Figure 17.
- La Figure 19 est similaire à la Figure 18 le moyen de validation étant activé.
- La Figure 20 est un schéma d'un autre mode de réalisation du détecteur de la Figure 5 intégrant un moyen de validation.
- La Figure 21 représente un détecteur de position et de déplacement réalisé selon un mode simplifié.

### DESCRIPTION DES MODES DE REALISATION PREFERES

Dans la suite de la description des éléments identiques ou similaires seront désignés par les mêmes références.

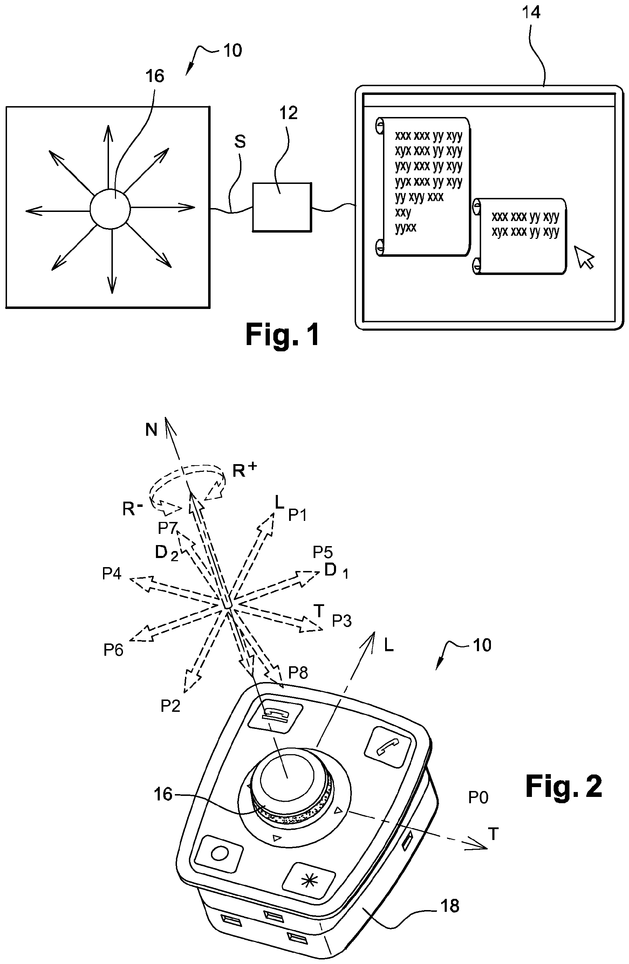

Sur la Figure 1 on a schématisé un dispositif de commande 10 connecté à une unité centrale 12 et à un écran de contrôle 14. Le dispositif 10 est pourvu d'un organe de commande 16 déplaçable en plusieurs directions, repérées par des flèches, de sorte à générer et transmettre des signaux S interprétables par l'unité centrale 12 pour piloter un curseur digital vers une des commandes proposées à l'écran 14 puis pour valider cette commande.

Sur la Figure 2, le dispositif 10 est repéré dans un repère orthogonal direct TLN comprenant les axes principaux transversal T et longitudinal L, et l'axe normal N. Le dispositif 10 comprend un boitier 18 de la face supérieur duquel émerge l'organe de commande 16. Dans cette illustration, des boutons de commandes sont agencés au voisinage immédiat de l'organe de commande 16 mais d'autres choix peuvent être faits et cet exemple n'est pas limitatif de l'invention. De même, un levier, une boule ou d'autres organes de commandes peuvent être préférés à la molette représentée. Enfin la face supérieure du boitier 18 est ainsi désignée par simple commodité sans aucune intention de limiter l'installation du dispositif 10 à quelque orientation particulière.

Sur la Figure 2, l'organe de commande 16 est représenté en une position neutre P0 située à l'origine du repère TLN. De cette position neutre P0 il peut être écarté en translation longitudinale L vers une position avant P1 et vers une position arrière P2, en translation transversale T vers une position droite P3 et vers une position gauche P4 et, en translation diagonale, en biais des axes principaux T, L, selon une première diagonale D1 vers une position avant-droite P5 et vers une position arrière-gauche P6 et selon une seconde diagonale D2 vers une position avant-gauche P7 et vers une position arrière-droit P8. L'organe de commande 16 peut de plus être tourné selon l'axe normal N dans le sens anti-horaire R+, sens positif de rotation, et dans le sens horaire R-, sens négatif de rotation. Enfin, une fois la commande désirée atteinte, celle-ci peut être validée par un appui sur l'organe de commande 16 qui s'enfonce selon une translation normale N vers une position appuyée PV.

Dans un mode de réalisation préféré, les translations de l'organe de commande 16 sont indépendantes des rotations R+, R- qui ne se font qu'en positon neutre P0. De plus, les translations, à l'instar des touches d'un clavier d'ordinateur, sont des déplacements limités de faible amplitude, quelques millimètres à peine. Par contre les rotations R+, R-, peuvent être illimitées.

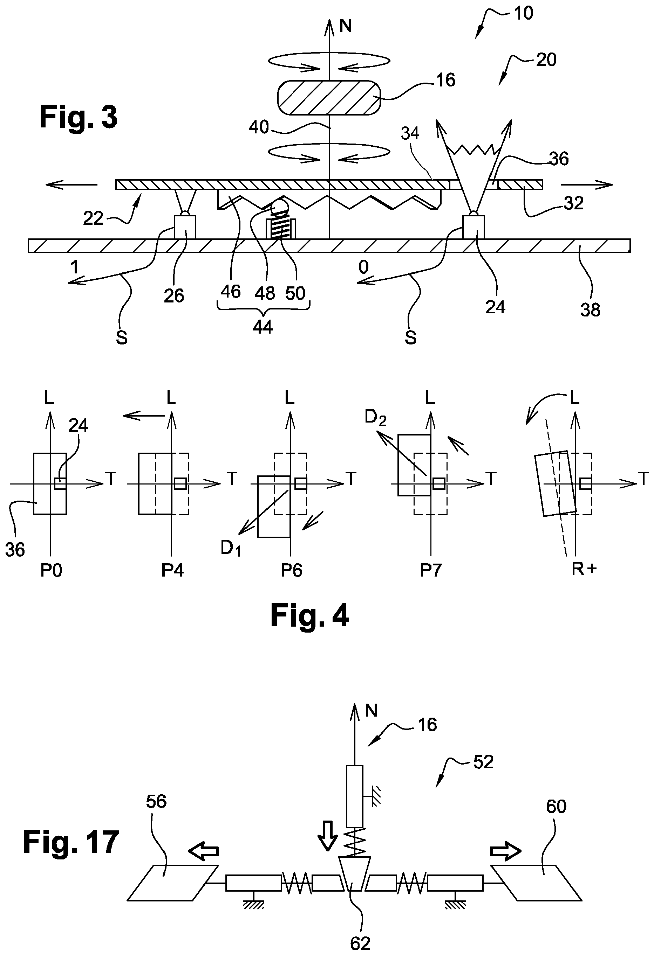

Selon la Figure 3, les signaux interprétables S sont générés par un détecteur 20 de déplacement lié à l'organe de commande 16. Le détecteur 20 comprend des capteurs actifs binaires 24, 26, qui émettent un signal et qui commutent au passage à leur endroit d'un marqueur passif 36 de sorte à émettre un autre signal. Par exemple, les capteurs optoélectroniques génèrent le signal « 1 » lorsqu'émettant un rayon lumineux incident, une surface réfléchissante 22 leur renvoie le rayon réfléchit et, ils commutent et génèrent le signal « 0 » lorsqu'ils sont face à une surface mate non-réfléchissante, ou face à une ouverture qui laisse passer le rayon incident. D'autres types de capteurs binaire existent tels des aimants attirés par un marqueur métallique.

Selon un premier mode de réalisation, le détecteur 20 est pourvu de quatre capteurs binaire optoélectronique 24, 26, 28, 30, d'un support de marqueurs 32 pourvu d'une partie discale 34 plane et perpendiculaire à l'axe normal N, et dans laquelle des marqueurs 36 ont été réalisés sous la forme d'ouvertures. Les capteurs 24-30 agencés sur une carte électronique 38 fixée dans le boitier 18 émettent un rayon lumineux en direction de la surface réfléchissante 22 de la partie discale 34, et commutent du signal 1 au signal 0 au passage d'une ouverture 36. Une construction inverse dans laquelle la surface de la partie discale est mate et les marqueurs sont réfléchissants, les capteurs commutant alors de 0 à 1 est une alternative possible.

La partie discale 34 est liée à un arbre 40 s'étendant selon l'axe normal N jusqu'à l'extérieur du boitier 18 où lui est fixé l'organe de commande 16 de sorte que, l'organe de commande 16 déplace de manière identique le support 32 et les marqueurs 36 relativement aux capteurs 24-30. Alternativement, les capteurs 24-30 pourraient être solidaires du support 32, qui deviendrait alors un support de capteurs, et les marqueurs 36 solidaires du boitier 18.

Le dispositif 10 est de plus pourvu de moyens de guidage (non représentés) guidant les translations et les rotations du support de marqueurs 32, de l'arbre 40 et de l'organe de commande 16.

Dans ce premier mode de réalisation, et en se référant à la Figure 4, chaque marqueur 36 est une ouverture rectangulaire de longueur supérieure à la taille d'un capteur 24. La Figure 4 illustre les déplacements significatifs du marqueur 36 relativement au capteur 24. En position neutre P0 - à gauche - le capteur 24 est face au marqueur 36 au voisinage immédiat du milieu du côté droit et il émet alors un signal 0. À partir de cette position P0 chacun des quatre déplacements suivants éloigne le marqueur 36 du capteur 24 qui commute alors vers le signal 1 : la translation transversale T vers la gauche P4, la translation en biais selon la première diagonale D1 vers l'arrière-gauche P6, la translation en biais selon la seconde diagonale D2 vers l'avant-gauche P7 et, la rotation anti-horaire R+. De multiples alternatives peuvent être choisies pour la forme du marqueur, ainsi, plutôt qu'un rectangle, on pourra choisir plusieurs petits marqueurs voisins chacun étant spécifique à un déplacement particulier. L'essentiel est que plusieurs déplacements du support de marqueurs fassent commuter un même capteur.

Les quatre capteurs 24, 26, 28, 30, génèrent individuellement des signaux 0 ou 1, qui regroupés forment une signature binaire à quatre chiffres.

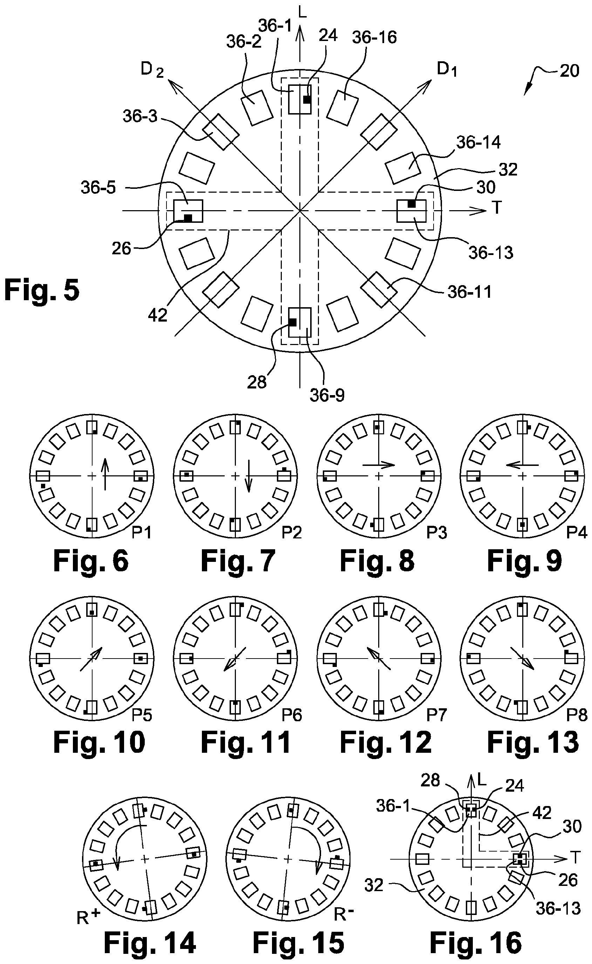

Les Figures 5 à 15 représentent les quatre capteurs 24-30 fixes et le support de marqueurs 32 placé en des positions différentes de sorte que les capteurs 24-30 génèrent à chaque fois une signature binaire à quatre chiffres spécifique à chacune des positions du support 32. Le Tableau 1 rapporte de manière synthétique les positions ainsi que les signatures spécifiques de chacune d'entre elles.

Dans ce mode de réalisation, le premier capteur 24 est placé à l'avant du détecteur 20, le deuxième capteur 26 est à gauche, le troisième capteur 28 est à l'arrière et le quatrième capteur 30 est à droite. Les marqueurs 36 sont au nombre de seize, référencés de 36-1 à 36-16, en tournant dans le sens anti-horaire. Ils sont équirépartis tous les 22,5° à la périphérie du support 32.

En positon neutre P0 - Figure 5 - deux marqueurs longitudinaux 36-1, 36-9, sont alignés sur l'axe longitudinal L respectivement à l'avant 36-1 et à l'arrière 36-9 et deux marqueurs transversaux 36-5, 36-13, sont alignés sur l'axe transversal T respectivement à gauche 36-5 et à droite 36-13. Le capteur avant 24 est face au marqueur avant 36-1 et au milieu de son côté droit. Le capteur gauche 26 est face au marqueur gauche 36-5 et au milieu de son côté arrière. Le capteur arrière 28 est face au marqueur arrière 36-9 et au milieu de son côté gauche. Enfin, le capteur droit 30 est face au marqueur droit 36-13 et au milieu de son côté avant. Les quatre capteurs étant face à un marqueur, ils émettent ensemble la signature 0000 qui, dans l'exemple de construction choisi est la signature neutre S0 identifiant la position neutre P0.

Les marqueurs sont agencés selon un motif élémentaire 42 répété autour du support 32. Le motif élémentaire 42 pour le détecteur 20 des Figures 5-15, est une croix à quatre branches perpendiculaires constituée des deux marqueurs longitudinaux 36-1, 36-9 et des deux marqueurs transversaux 36-5, 36-13. Ce motif en croix est reproduit tous les 22,5° de sorte à avoir en tout seize marqueurs 36. Un autre angle de reproduction aurait pu être choisi, par exemple 10° et alors se sont trente-six marqueurs qui seraient agencés sur le support 32.

Les marqueurs et les capteurs peuvent être agencés relativement les uns aux autres selon de très nombreuses alternatives. Par exemple, selon la Figure 16, les deux capteurs longitudinaux 24, 28, sont face au marqueur avant 36-1 sur ses côtés droit et gauche et les deux capteurs transversaux 26, 30, sont face au marqueur droit 36-13 sur ses côtés avant et arrière. Le motif élémentaire 42 est alors un L ne comprenant que les deux marqueurs avant 36-1 et droit 36-13.

Selon un autre mode de réalisation non représenté, les marqueurs 36 sont carrés et les quatre capteurs 24-30 sont agencés en face d'un même marqueur 36, chacun étant au milieu de l'un des côtés du marqueur 36.

Dans encore une autre réalisation non représenté, les capteurs sont radialement alignés et un marqueur ondulé se place, en position neutre, de sorte que les capteurs soient au creux des ondulations. Un déplacement du marqueur fait alors commuter un ou plusieurs capteurs, le motif élémentaire 42 des marqueurs étant alors une ligne ondulée. L'homme du métier saura ajuster les positions respectives nécessaires pour faire varier la signature binaire à quatre chiffres à chaque déplacement.

Par ailleurs, les signatures binaires à quatre chiffres sont ordonnées selon l'ordre dans lequel les capteurs sont repérés. Dans le Tableau 1 les signatures sont ordonnées selon l'ordre des capteurs 24-26-28-30. Un ordre différent des capterus donnerait des signatures différentes.

Les signatures S0-S8 correspondant respectivement aux positions P0-P8 doivent être distinguées des signatures SR+, SR-, correspondant aux rotations R+, R-. En effet, la signature des positions atteintes suite à une translation est spécifique à la position et non au parcours qui l'y mène. Dans un mode de réalisation préféré, le passage d'une position à une autre position se fait selon une série de translations radiales passant par la position neutre P0. Par exemple le passage de la position avant P1 à la position droite P3 commence par une translation longitudinale jusqu'à la position neutre P0 puis une translation transversale jusqu'à la position droite P3. Selon un autre mode de réalisation, le passage d'une position à une autre position peut se faire selon une translation directe entre les deux positions périphériques. Le passage de la position avant P1 à la position droite P3 suit alors une seule translation parallèle à la seconde diagonale D2 directement de la position avant P1 à la position droite P3. Quel que soit le parcours suivi, translations radiales ou translation directe, l'unité centrale 12 interprétera les signatures émises comme étant celles des positions de l'organe de commande 16.

Par contre, une rotation R+, R-, va entrainer une succession de signatures suivant une suite ordonnée. Selon les Figures 5, 14 et 15, une rotation positive R+ au départ de la position neutre P0 va générer une suite de signatures binaires à quatre chiffres telle que 0000/1010/0101 puis à nouveau 0000 lorsque le support de marqueurs 32 aura tourné de 22,5°. L'unité centrale 12 interprète cette suite ordonnée comme étant significative d'une rotation positive R+. Similairement, une rotation négative R- au départ de la position neutre P0 va générer la suite de signatures inverse 0000/0101/1010 puis à nouveau 0000... L'unité centrale 12 interprète alors cette suite ordonnée inverse comme étant significative d'une rotation négative R-.

De plus, l'unité centrale 12 considère que la rotation détectée se poursuit tant que les signatures changent en suivant l'ordre de la suite.

Une autre possibilité d'interprétation est que l'unité centrale 12 ne considère que le premier changement de signature 0000/1010, S0/SR+, pour une rotation positive R+ et, 0000/0101, S0/SR-, pour une rotation négative R-. Une fois ce premier changement repéré, l'unité centrale 12 n'observe plus les signatures exactes mais uniquement le changement de signatures et, tant que la signature varie alors l'unité centrale 12 considère que la rotation correspondant au premier changement observé se poursuit.

Quel que soit le mode choisi, la rotation est significative d'une succession de signatures correspondant au passage des motifs élémentaires 42 de marqueurs 36 devant les capteurs 24-30.

Dans un mode de réalisation préféré, la rotation de l'organe de commande 16 ne peut se faire qu'en position neutre P0. La signature neutre S0 de la position neutre P0 est donc émise plusieurs fois par révolution du support 32, seize fois pour le mode de réalisation des Figures 5-15. De plus, la signature neutre S0 est toujours le point de départ de la suite de signatures significative d'une rotation. Dans un autre mode de réalisation, l'organe de commande 16 peut tourner, R+, R-alors qu'il se trouve déjà en une position écartée de la position neutre P0, par exemple en position avant P1. Dans ce cas, l'unité centrale 12 doit pouvoir reconnaître une rotation R+, R-, en observant une autre suite ordonnée ou bien un autre premier changement de signature.

Dans le mode de réalisation préféré, à la fin d'une rotation, le support de marqueurs 32 s'immobilise en une position identifiée par la signature neutre S0. Pour ce faire, le dispositif 10 est pourvu d'un moyen d'indexation et de rappel 44 du support de marqueurs 32 vers une position stable identifiée par la signature neutre S0. Le moyen d'indexation 44 représenté sur la Figure 3 comprend une couronne dentée 46 solidaire du support 32 contre laquelle une bille 48 est sollicitée en permanence par un ressort 50 solidaire du boitier 18. Lors d'une rotation R+, R-, la bille 48 parcours le chemin denté et, à la fin de la rotation, la bille 48 pressée entre deux dents immobilise la couronne 46, et donc le support 32 de marqueurs, en une position stable correspondant à une position identifiée par la signature neutre S0. De multiples alternatives existent pour réaliser ce genre de moyen d'indexation.

Par ailleurs, lorsque suite à une translation, le support 32 a été écarté de la position neutre P0 le moyen de rappel 44 doit le solliciter vers un retour à la position neutre P0. Le moyen 44 comprend alors un autre moyen élastique (non représenté) que sollicite radialement le support 32 vers la position neutre P0.

Le dispositif 10 peut de plus être pourvu d'un moyen de validation 52 dont un premier mode de réalisation est représenté sur les Figures 17, 18 et 19. Alors que le support de marqueurs 32 est en position neutre P0, le moyen de validation 52 a pour objet de faire commuter les capteurs 24-30 de la signature neutre S0 vers une signature de validation SV différente de toutes les signatures binaire à quatre chiffres déjà utilisées. Ainsi l'utilisateur, après avoir sélectionné la fonction désirée peut la valider en actionnant le moyen 52. La validation d'une fonction est une des alternatives possibles à l'utilisation du moyen 52 qui pourrait également être utilisé pour faire défiler les applications disponibles à l'écran en passant par exemple de la radio, à l'écran de gestion de l'air conditionné, au GPS etc...

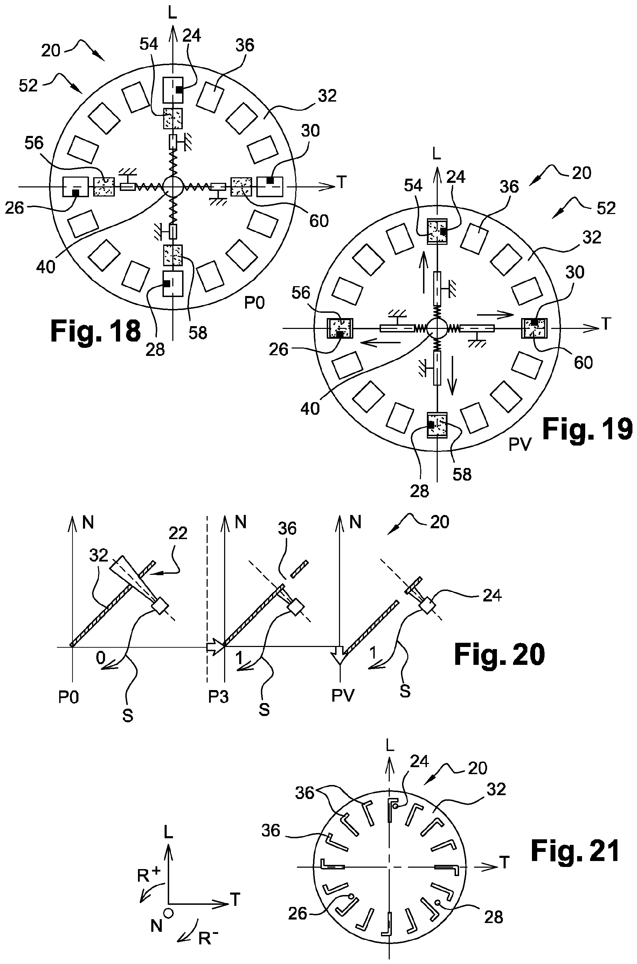

Dans le mode de réalisation représenté sur les Figures 17, 18 et 19, la signature neutre S0 est 0000 et la signature de validation SV est 1111. Cette commutation est réalisée en plaçant simultanément en face de chacun des quatre capteurs 24, 26, 28, 30, un écran réflecteur 54, 56, 58, 60, faisant tous les capteurs commuter en même temps du signal 0 au signal 1. Les écrans réflecteurs 54-60 sont normalement en une position repos - Figure 18 - à proximité de l'arbre 40. En appuyant sur l'organe de commande 16 selon l'axe normal N - Figure 17 - un coin 62 écarte radialement et simultanément les écrans réflecteurs 54-60 de sorte qu'ils s'agencent au droit des capteurs 24-30. Des ressorts rappellent radialement les écrans réflecteurs 54-60 en position de repos dès que l'appui normal N est terminé. Le moyen de validation 52 ainsi réalisé est solidaire des translations longitudinales L et transversales T du support 32 de marqueurs. Par contre il ne tourne pas et demeure toujours orienté selon ces deux axes principaux T, L.

Un autre mode de réalisation du moyen de validation 52 est esquissé en Figure 20. Dans cet autre mode, le support de marqueurs 32 est conique et les capteurs 24-30 émettent un rayon lumineux incliné perpendiculaire au cône. À gauche de la Figure 20 le rayon passe au travers du marqueur et le capteur envoie un signal 0. Une translation du support 32 vers la droite - Figure 20 centre - ou un appui selon l'axe normal N - Figure 20 droite - déplace le marqueur faisant commuter le capteur vers le signal 1.

Le dispositif 10 décrit utilise douze signatures binaires à quatre chiffres répertoriées dans le Tableau 1.

**Tableau 1**

| Figures | Positions | Référence des positions | Signature | Référence des signatures |
|---|---|---|---|---|
| 5 | Neutre | P0 | 0000 | S0 |
| 6 | Avant | P1 | 0100 | S1 |
| 7 | Arrière | P2 | 0001 | S2 |
| 8 | Droite | P3 | 0010 | S3 |
| 9 | Gauche | P4 | 1000 | S4 |
| 10 | avant-droite | P5 | 0110 | S5 |
| 11 | arrière-gauche | P6 | 1001 | S6 |
| 12 | avant-gauche | P7 | 1100 | S7 |
| 13 | arrière-droite | P8 | 0011 | S8 |
| 14 | rotation anti-horaire | R+ | 1010 | SR+ |
| 15 | rotation horaire | R- | 0101 | SR- |
| 19 | Validation | PV | 1111 | SV |

Quatre signatures binaires à quatre chiffres demeurent donc disponibles. Dans l'exemple choisi précédemment et résumé dans le Tableau 1 ces signatures non utilisées sont 0111, 1011, 1101 et 1110. Le dispositif 10 peut alors être réalisé selon un mode augmenté utilisant les seize signatures binaires actionnant quatre fonctionnalités supplémentaires.

Les quatre fonctionnalités supplémentaires peuvent être de nouveaux déplacements, par exemple, plutôt qu'une seule translation intermédiaire, D1, D2, entre chaque direction principale T, L, il est concevable que l'organe de commande 16 se déplace selon deux translations intermédiaires par exemple orientées tous les 30°.

On peut également concevoir que dans une direction, par exemple longitudinale L vers l'avant, plutôt que d'avoir une seule position avant P1 on puisse déplacer l'organe de commande vers une première position avant puis, encore plus vers l'avant, jusqu'à une seconde position avant.

Alternativement les quatre signatures encore disponibles peuvent être utilisées pour actionner des fonctions via des moyens annexes dédiés déplaçant des écrans réflecteurs ou des marqueurs additionnels faisant commuter les capteurs. Ces moyens annexes peuvent par exemple être des boutons de commande périphérique à l'organe de commande 16.

Également, les quatre signatures disponibles peuvent être utilisées pour actionner des fonctions via une combinaison de déplacements tels une rotation et une translation, ou une translation longitudinale L et une translation normale N. Selon l'invention le dispositif 10 est réalisé selon au mode simplifié à trois capteurs binaires ne pouvant donc émettre que huit signatures binaires à trois chiffres. Ce mode de réalisation est particulièrement adapté à un dispositif 10 dont l'organe de commande 16 ne peut se déplacer depuis une position neutre que selon quatre translations selon les axes longitudinal L et transversal T, deux rotations R+, R- autour de l'axe normal N et une validation par appui selon l'axe normal N, sans possibilité de déplacement diagonal D1, D2. La Figure 21 propose un support de marqueurs 32 placé en position neutre P0 et dont chaque déplacement est identifiable par une signature binaire à trois chiffres rapportée dans le Tableau 2 ci-dessous.

**Tableau 2**

| Positions | Référence des positions | Signatures |
|---|---|---|
| neutre | P0 | 000 |
| avant | P1 | 011 |
| arrière | P2 | 100 |
| droite | P3 | 101 |
| gauche | P4 | 010 |
| rotation anti-horaire | R+ | 001 |
| rotation horaire | R- | 110 |
| validation | PV | 111 |

## Revendications

1. Dispositif (10) de commande destiné au choix et à la sélection de fonctions dans un véhicule, le dispositif (10) comprenant trois capteurs (24, 26, 28) actifs binaires, agencés sur une carte électronique (38) fixée dans un boitier (18), les capteurs (24, 26, 28) commutant au passage de marqueurs (36) passifs agencés sur un support (32) déplaçable au moyen d'un organe de commande (16) manipulable, le support (32) étant déplaçable :
en translation selon un premier axe principal longitudinal (L) vers une position avant (P1) et une position arrière (P2) et perpendiculairement selon un second axe principal transversal (T) vers une position droite (P3) et une position gauche (P4) et,
en rotation autour d'un axe normal (N) perpendiculaire aux axes principaux (T, L) dans le sens horaire (R-) et dans le sens anti-horaire (R+),
le support (32) de marqueurs et l'organe de commande (16) étant de plus en liaison avec un moyen d'indexation et de rappel (44) qui les sollicite en permanence vers une position neutre (P0),
les capteurs (24, 26, 28) et les marqueurs (36) étant agencés relativement les uns aux autres de sorte que chacune des cinq positions, neutre (P0), avant (P1), arrière (P2), droite (P3), gauche (P4) ainsi que chacune des deux rotations horaire (R-) et anti-horaire (R+) est individuellement identifiée par une signature (S0, S1, S2, S3, S4, SR-, SR+) binaire à trois chiffres émise par les capteurs (24, 26, 28).

2. Dispositif (10) selon la revendication précédente dans lequel l'organe de commande (16) et le support de marqueurs (32) sont de plus mobiles en translation dans quatre directions coplanaires et intermédiaires des axes principaux (T, L) depuis la position neutre (P0) vers une position avant-droite (P5) et vers une position arrière-gauche (P6) et vers une position avant-gauche (P7) et une position arrière-droite (P8), le dispositif (10) étant pourvu d'un quatrième capteur (30) actif binaire et,
les quatre capteurs (24, 26, 28, 30) et les marqueurs (36) étant agencés relativement les uns aux autres de sorte que chacune des neuf positions, neutre (P0), avant (P1), arrière (P2), droite (P3), gauche (P4) et intermédiaires (P5, P6, P7, P8) ainsi que chacune des deux rotations horaire (R-) et anti-horaire (R+) est individuellement identifiée par une signature binaire à quatre chiffres (S0, S1, S2, S3, S4, S5, S6, S7, S8, SR+, SR-) émise par les capteurs (24, 26, 28, 30).

3. Dispositif (10) selon l'une quelconque des revendications précédentes dans lequel
le support de marqueurs (32) comprend une surface de révolution (34) d'axe normal (N) à la périphérie de laquelle les marqueurs (36) sont agencés avec régularité selon un espacement angulaire constant de sorte que
la signature neutre (S0) de la position neutre (P0) est émise chaque fois que le support de marqueurs (32) tourne (R+, R-) dudit angle d'espacement angulaire et donc, la signature neutre (S0) de la position neutre (P0) est émise plusieurs fois par révolution du support de marqueurs (32) et dans lequel,
à la suite d'une rotation (R-, R+), le moyen d'indexation et de rappel (44) immobilise le support de marqueurs (32) en une position angulaire stable identifiée par la signature neutre (S0).

4. Dispositif (10) selon la revendication 3 dans lequel le moyen d'indexation et de rappel (44) comprend une couronne dentée (46) solidaire du support de marqueurs (32) et un indexeur (48) pressé contre la couronne (46) par un moyen élastique (50), l'indexeur (48) et le moyen élastique (50) étant maintenus solidaire du boitier (18),
la couronne (46) ayant autant de dents que le support de marqueurs (32) a de position angulaire identifiée par la signature neutre (S0), la couronne (46) étant agencée sur le support (32) de sorte qu'à l'arrêt, l'indexeur (48) se trouve pressé entre deux dents de la couronne (46) stabilisant le support (32) en une des positions angulaires stables identifiées par la signature neutre (S0).

5. Dispositif (10) selon l'une quelconque des revendications précédentes dans lequel les signatures binaires encore disponibles sont utilisées pour identifier des fonctions supplémentaires actionnées par l'intermédiaire de nouveaux déplacements de l'organe de commande (16) ou d'actionneurs supplémentaires dédiés.

6. Dispositif (10) selon la revendication 5 pourvu en outre d'un moyen annexe de commande (52) activé par un appui selon l'axe normal (N) sur l'organe de commande (16) le faisant translater de la position neutre (P0) vers une position appuyée (PV) et faisant commuter les capteurs (24, 26, 28, 30) de sorte qu'ils émettent une signature binaire (SV) identifiant la position appuyée (PV), le moyen d'indexation et de rappel (44) sollicitant l'organe de commande (16) vers un retour à la position neutre (P0).

7. Dispositif (10) selon l'une quelconque des revendications précédentes dans lequel les capteurs (24, 26, 28, 30) sont des capteurs optiques émetteur et récepteur d'un rayon lumineux et dans lequel, la partie du support de marqueurs (32) agencée en regard des capteurs (24, 26, 28, 30) est une surface réfléchissante du rayon lumineux et, les marqueurs sont des zones non réfléchissantes de sorte que,
un capteur (24, 26, 28, 30) émettant un rayon lumineux incident commute lorsqu'au passage d'un marqueur (36) le rayon lumineux ne lui est plus réfléchit.

8. Dispositif (10) selon l'une quelconque des revendications précédentes pourvu de plus de moyens de guidage guidant les déplacements de l'organe de commande (16) en translation et en rotation.

## Patentansprüche

1. Steuervorrichtung (10) zur Auswahl und Selektion von Funktionen in einem Fahrzeug, wobei die Vorrichtung (10) drei binäre aktive Sensoren (24, 26, 28) umfasst, die auf einer in einem Gehäuse (18) befestigten elektronischen Karte (38) angeordnet sind, wobei die Sensoren (24, 26, 28) beim Übergang von passiven Markern (36), die auf einem Träger (32) angeordnet sind, der mittels eines betätigbaren Steuerorgans (16) verlagerbar ist, umschalten, wobei der Träger (32)
in Translation entlang einer longitudinalen ersten Hauptachse (L) in eine vordere Position (P1) und in eine hintere Position (P2) und senkrecht entlang einer transversalen zweiten Hauptachse (T) in eine rechte Position (P3) und in eine linke Position (P4) verlagerbar ist und
in Rotation um eine normale Achse (N) senkrecht zu den Hauptachsen (T, L) im Uhrzeigersinn (R-) und im Gegenuhrzeigersinn (R+) verlagerbar ist, wobei der Markerträger (32) und das Steuerorgan (16) ferner mit einer Indexier- und Rückführeinrichtung (44) verbunden sind, welche diese dauerhaft in eine neutrale Position (P0) beaufschlagt,
wobei die Sensoren (24, 26, 28) und die Marker (36) relativ zueinander so angeordnet sind, dass jede der fünf Positionen, neutral (P0), vorn (P1), hinten (P2), rechts (P3), links (P4), und jede der beiden Drehungen im Uhrzeigersinn (R-) und im Gegenuhrzeigersinn (R+) einzeln durch eine dreistellige binäre Signatur (S0, S1, S2, S3, S4, SR-, SR+) identifiziert wird, die von den Sensoren (24, 26, 28) emittiert wird.

2. Vorrichtung (10) nach dem vorangehenden Anspruch, wobei das Steuerorgan (16) und der Markerträger (32) zudem in vier koplanaren Zwischenrichtungen der Hauptachsen (T, L) von der neutralen Position (P0) in eine Position recht-vorn (P5) und in eine Position links-hinten (P6) und in eine Position links-vorn (P7) und in eine Position rechts-hinten (P8) translatorisch verlagerbar sind, wobei die Vorrichtung (10) mit einem vierten aktiven binären Sensor (30) versehen ist, und
die vier Sensoren (24, 26, 28, 30) und die Marker (36) relativ zueinander so angeordnet sind, dass jede der fünf Positionen, neutral (P0), vorn (P1), hinten (P2), rechts (P3), links (P4), und die Zwischenpositionen (P5, P6, P7, P8) sowie jede der beiden Drehungen im Uhrzeigersinn (R-) und im Gegenuhrzeigersinn (R+) einzeln durch eine vierstellige binäre Signatur (S0, S1, S2, S3, S4, S6, S7, S8, SR-, SR+) identifiziert wird, die von den Sensoren (24, 26, 28, 30) emittiert wird.

3. Vorrichtung (10) nach einem der vorangehenden Ansprüche, wobei der Markerträger (32) eine Umlauffläche (34) mit normaler Achse (M) enthält, an deren Umfang die Marker (36) gleichmäßig im konstanten Winkelabstand angeordnet sind, so dass
die neutrale Signatur (S0) der neutralen Position (P0) jedes Mal dann emittiert wird, wenn der Markerträger (32) um den Winkel des Winkelabstands gedreht wird (P+, R-) und somit die neutrale Signatur (S0) der neutralen Position (P0) durch Umlauf des Markerträgers (32) mehrere Male emittiert wird, und wobei
nach einer Drehung (R-, R+) die Indexier- und Rückführeinrichtung (44) den Markerträger (32) in einer stabilen Winkelposition festlegt, die von der neutralen Signatur (S0) identifiziert wird.

4. Vorrichtung (10) nach Anspruch 3, wobei die Indexier- und Rückführeinrichtung (44) einen Zahnkranz (46) enthält, der fest mit dem Markerträger (32) verbunden ist, sowie einen Zeiger (48), der von einem Federmittel (50) gegen den Kranz (46) gedrückt wird, wobei der Zeiger (48) und das Federmittel (50) fest mit dem Gehäuse (18) verbunden gehalten werden,
wobei der Kranz (46) ebenso viele Zähne hat wie der Markerträger (32) Winkelpositionen hat, die von der neutralen Signatur (S0) identifiziert werden, wobei der Kranz (46) an dem Träger (32) so angeordnet ist, dass bei Stillstand der Zeiger (48) zwischen zwei Zähne des Kranzes (46) angedrückt wird, wodurch der Träger (32) in einer der stabilen Winkelpositionen stabilisiert wird, die von der neutralen Signatur (S0) identifiziert werden.

5. Vorrichtung (10) nach einem der vorangehenden Ansprüche, wobei die weiterhin verfügbaren binären Signaturen dazu verwendet werden, zusätzliche Funkionen zu identifizieren, die über erneute Verlagerungen von dem Steuerorgan (16) oder von zugeordneten zusätzlichen Betätigungsgliedern betätigt werden.

6. Vorrichtung (10) nach Anspruch 5, ferner versehen mit einer Steuerhilfseinrichtung (52), die durch Drücken auf das Steuerglied (16) entlang der normalen Achse (N) aktiviert wird und dieses von der neutralen Position (P0) in eine gedrückte Position (PV) verschiebt und die Sensoren (24, 26, 28, 30) so umschaltet, dass sie eine binäre Signatur (SV) emittieren, welche die gedrückte Position (PV) identifiziert, wobei die Indexierungs- und Rückführeinrichtung (44) das Steuerorgan (16) zu einer Rückkehr in die neutrale Position (P0) beaufschlagt.

7. Vorrichtung (10) nach einem der vorangehenden Ansprüche, wobei die Sensoren (24, 26, 28, 30) optische Sensoren zum Emittieren und Empfangen eines Lichtstrahls sind und wobei der den Sensoren (24, 26, 28, 30) gegenüberliegende Abschnitt des Markerträgers (32) eine den Lichtstrahl reflektierende Fläche ist und die Marker nicht reflektierende Bereiche sind, so dass
ein Sensor (24, 26, 28, 30), der einen einfallenden Lichtstrahl emittiert, dann umschaltet, wenn beim Übergang von einem Marker (36) der Lichtstrahl nicht mehr zu diesem reflektiert wird.

8. Vorrichtung (10) nach einem der vorangehenden Ansprüche, ferner versehen mit Führungseinrichtungen, welche die Verlagerungen des Steuerorgans (16) in Translation und Rotation führen.

## Claims

1. Control device (10) intended for choosing and selecting functions in a vehicle, the device (10) comprising
three active binary sensors (24, 26, 28), arranged on an electronic board (38) fixed in a housing (18), the sensors (24, 26, 28) switching on passing passive markers (36) arranged on a support (32) that can be moved by means of a manipulatable control member (16), the support (32) being moveable:
in translational movement along a longitudinal first main axis (L) towards a forward position (P1) and a back position (P2) and perpendicular to that along a transverse second main axis (T) towards a right position (P3) and a left position (P4), and
in rotational movement about a normal axis (N) perpendicular to the main axes (T, L) in the clockwise direction (R-) and in the anticlockwise direction (R+), the marker support (32) and the control member (16) additionally being in connection with an indexing and return means (44) which urges them constantly towards a neutral position (P0),
the sensors (24, 26, 28) and the markers (36) being arranged relative to one another in such a way that each of the five positions, neutral (P0), forward (P1), back (P2), right (P3), left (P4) and each of the two clockwise (R-) and anticlockwise (R+) rotations is individually identified by a three-digit binary signature (S0, S1, S2, S3, S4, SR-, SR+) emitted by the sensors (24, 26, 28).

2. Device (10) according to the preceding claim, in which the control member (16) and the marker support (32) are additionally able to move in a translational movement in four coplanar and intermediate directions of the main axes (T, L) from the neutral position (P0) towards a forward-right position (P5) and towards a back-left position (P6) and towards a forward-left position (P7) and a back-right position (P8), the device (10) being provided with a fourth active binary sensor (30), and
the four sensors (24, 26, 28, 30) and the markers (36) being arranged relative to one another in such a way that each of the nine positions, neutral (P0), forward (P1), back (P2), right (P3), left (P4) and intermediate (P5, P6, P7, P8) as well as each of the two clockwise (R-) and anticlockwise (R+) rotations is individually identified by a four-digit binary signature (S0, S1, S2, S3, S4, S5, S6, S7, S8, SR+, SR-) emitted by the sensors (24, 26, 28, 30).

3. Device (10) according to either one of the preceding claims, in which
the marker support (32) comprises a surface of revolution (34) of normal axis (N), at the periphery of which the markers (36) are arranged uniformly at a constant angular spacing so that
the neutral signature (S0) of the neutral position (P0) is emitted each time the marker support (32) rotates (R+, R-) through the said angular-spacing angle and, therefore, the neutral signature (S0) of the neutral position (P0) is emitted several times per revolution of the marker support (32), and in which,
following a rotation (R-, R+), the indexing and return means (44) immobilize the marker support (32) in a stable angular position identified by the neutral signature (S0).

4. Device (10) according to Claim 3 in which the indexing and return means (44) comprises a crown gear (46) secured to the marker support (32) and an indexing element (48) pressed against the crown gear (46) by an elastic means (50), the indexing element (48) and the elastic means (50) being kept secured to the housing (18),
the crown gear (46) having as many teeth as the marker support (32) has angular positions identified by the neutral signature (S0), the crown gear (46) being arranged on the support (32) in such a way that, when stationary, the indexing element (48) is pressed between two teeth of the crown gear (46), stabilizing the support (32) in one of the stable angular positions identified by the neutral signature (S0).

5. Device (10) according to any one of the preceding claims, in which the binary signatures still available are used to identify additional functions actuated by means of new movements of the control member (16) or of dedicated additional actuators.

6. Device (10) according to Claim 5, further provided with an ancillary control means (52) activated by pressing on the control member (16) along the normal axis (N) to make the member move translationally from the neutral position (P0) towards a pressed position (PV) and causing the sensors (24, 26, 28, 30) to switch so that they emit a binary signature (SV) identifying the pressed position (PV), the indexing and return means (44) urging the control member (16) toward a return to the neutral position (P0).

7. Device (10) according to any one of the preceding claims, in which the sensors (24, 26, 28, 30) are optical sensors emitting and receiving a ray of light and in which that part of the marker support (32) that is arranged facing the sensors (24, 26, 28, 30) is a reflective surface that reflects the ray of light and the markers are non-reflective zones such that a sensor (24, 26, 28, 30) emitting an incident ray of light switches when, on passing a marker (36), the ray of light is no longer reflected back to it.

8. Device (10) according to any one of the preceding claims additionally provided with guide means guiding the movements of the control member (16) in translational and rotational movements.
